# EUROPEAN PATENT APPLICATION

(11) **EP 4 697 557 A1**
(43) Date of publication of application: **18.02.2026**
(21) Application number: 25794853.9
(22) Date of filing: 21.02.2025
(51) Int. Cl.: H02J 7/00, G01R 19/165, G01R 31/382

(54) **BATTERY CONTROL DEVICE AND METHOD**

(30) Priority: 24.04.2024 KR 20240054516
(71) Applicant: LG Energy Solution, Ltd., Seoul 07335 (KR)
(72) Inventor: LEE, Chung Yong, Daejeon 34122 (KR)
(74) Representative: BCKIP Part mbB
(86) International application number: PCT/KR2025/002489
(87) International publication number: WO 2025/225853

(57) **Abstract**

A battery control device according to an embodiment of the present invention is located in a battery system including a plurality of batteries, and may comprise: at least one processor; and a memory that stores at least one command that is executed through the at least one processor. The at least one command may include: a command for checking an operation mode of the battery system; a command for setting a reference voltage on the basis of a reference voltage setting criterion defined to correspond to the checked operation mode; a command for selecting target batteries having a voltage within a preset range of the reference voltage; and a command for controlling so that the target batteries are connected in parallel to each other.

## Description

### [Technical Field]

This application claims priority to and the benefit of Korean Patent Application No.10-2024- 0054516 filed in the Korean Intellectual Property Office on April 24, 2024 the entire contents of which are incorporated herein by reference.

The present invention relates to an apparatus and method for controlling battery, and more particularly, to an apparatus and method for controlling battery for improving power efficiency of a battery system.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements. For medium and large-sized devices such as an energy storage system (ESS) for smart grids, a high-capacity battery system with multiple battery racks connected in parallel may be applied to satisfy required capacity of the device.

In general, a battery system including parallel-connected batteries selects batteries with low voltage differences to prevent inrush current from occurring when switching batteries from a parallel disconnected state to a parallel connected state, and then connects the selected batteries to a DC link to connect them in parallel. Here, batteries connected to the DC link (online batteries) perform a charge/discharge process according to the operation mode of the battery system, and batteries not connected to the DC link (offline batteries) standby in an idle mode.

In order to improve power efficiency of the battery system, it is necessary to maximize the number of online batteries participating in the charge/discharge process and minimize the number of offline batteries.

Among the prior art documents relevant to the present invention, KR 10-2018-0009569 A is of some relevance.

### [Detailed Description of the Invention]

### [Technical Problem]

To obviate one or more problems of the related art, embodiments of the present disclosure provide a battery control apparatus for improving power efficiency of a battery system.

To obviate one or more problems of the related art, embodiments of the present disclosure also provide a battery control method performed by the battery control apparatus.

### [Technical Solution]

In order to achieve the objective of the present disclosure, a battery control apparatus may be a battery control apparatus located in a battery system including a plurality of batteries, which includes at least one processor; and a memory configured to store at least one instruction executed by the at least one processor.

Here, the at least one instruction may include an instruction to identify an operation mode of the battery system; an instruction to determine a reference voltage based on a reference voltage setting criterion defined in correspondence with the identified operation mode; an instruction to select one or more target batteries having a voltage within a predetermined range from the reference voltage; and an instruction to control the target batteries to be connected in parallel with each other.

The operation mode may include one or more of a charge mode, a discharge mode, and a charge/discharge mixed mode.

The instruction to identify the operation mode of the battery system may include an instruction to determine a current operation mode of the battery system based on charge/discharge schedule information including an operation mode for each time interval.

The instruction to determine the reference voltage may include an instruction to determine the lowest voltage value among voltage values of the batteries as the reference voltage when the battery system operates in a charge mode.

The instruction to determine the reference voltage may include an instruction to determine the highest voltage value among voltage values of the batteries as the reference voltage when the battery system operates in a discharge mode.

The instruction to determine the reference voltage may include an instruction to determine a voltage value of a specific battery among the batteries as the reference voltage when the battery system operates in a charge/discharge mixed mode.

The instruction to determine the reference voltage may include an instruction to determine, for each of the batteries, a number of other batteries each of which has a voltage value within a predetermined range of difference from the voltage value of each battery; and an instruction to determine the voltage value of the battery having the largest number of the other batteries, as the reference voltage.

The at least one instruction may further include an instruction to connect, in parallel with the target batteries, one or more batteries whose voltage difference with the target batteries falls into a predetermined range during a process of charging or discharging the target batteries, among one or more batteries from which the parallel connection has been disconnected.

The instruction to control the target batteries to be connected in parallel with each other may include an instruction to transmit a switch control signal for causing a switch connecting the battery and a direct current (DC) link to be switched to a closed state to a battery management apparatus of each of the target batteries.

According to another embodiment of the present disclosure, a battery control method may be performed by a battery control apparatus located in a battery system including a plurality of batteries, and the battery control method may include identifying an operation mode of the battery system; determining a reference voltage based on a reference voltage setting criterion defined in correspondence with the identified operation mode; selecting one or more target batteries having a voltage within a predetermined range from the reference voltage; and controlling the target batteries to be connected in parallel with each other.

The operation mode may include one or more of a charge mode, a discharge mode, and a charge/discharge mixed mode.

The identifying the operation mode of the battery system may include determining a current operation mode of the battery system based on charge/discharge schedule information including an operation mode for each time interval.

The determining the reference voltage may include determining the lowest voltage value among voltage values of the batteries as the reference voltage when the battery system operates in a charge mode.

The determining the reference voltage may include determining the highest voltage value among voltage values of the batteries as the reference voltage when the battery system operates in a discharge mode.

The determining the reference voltage may include determining a voltage value of a specific battery among the batteries as the reference voltage when the battery system operates in a charge/discharge mixed mode.

The determining the reference voltage may include determining, for each of the batteries, a number of other batteries each of which has a voltage value within a predetermined range of difference from the voltage value of each battery; and determining the voltage value of the battery having the largest number of the other batteries, as the reference voltage.

The method may further include connecting, in parallel with the target batteries, one or more batteries whose voltage difference with the target batteries falls into a predetermined range during a process of charging or discharging the target batteries, among one or more batteries from which the parallel connection has been disconnected.

The controlling the target batteries to be connected in parallel with each other may include transmitting a switch control signal for causing a switch connecting the battery and a direct current (DC) link to be switched to a closed state to a battery management apparatus of each of the target batteries.

### [Advantageous Effects]

According to the embodiments of the present invention as described above, a number of batteries participating in a charging/discharging process can be maximized, thereby improving power efficiency of a battery system.

### [Brief Description of theDrawings]

FIG. 1 is a block diagram of a general energy storage system.
FIG. 2 is a graph for explaining a general battery control method.
FIG. 3 is a block diagram of a battery system according to embodiments of the present invention.
FIG. 4 is an operational flowchart of a battery control method according to embodiments of the present invention.
FIG. 5 is an operational flowchart of a battery control method according to another embodiment of the present invention.
FIG. 6 is a reference table for explaining a method for determining a reference voltage in a charge/discharge mixed mode according to another embodiment of the present invention, and is an example of voltage difference between batteries.
FIG. 7 is a graph for explaining an active balancing method in a charging mode according to an embodiment of the present invention.
FIG. 8 is a graph for explaining an active balancing control method in a discharge mode according to an embodiment of the present invention.
FIG. 9 is a graph for explaining an active balancing control method in a charge/discharge mixed mode according to an embodiment of the present invention.
FIG. 10 is a block diagram of a battery control apparatusaccording to embodiments of the present invention.

100 : battery
200 : battery management apparatus
300, 1000: battery control apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery rack refers to a system of a single structure which is assembled by connecting module units set by a battery manufacturer in series/parallel and may be monitored and controlled by a battery management apparatus/system (BMS). A battery rack may include several battery modules (or battery packs) and a battery protection unit or any other protection device.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

State of Charge (SOC) refers to a current state of charge of a battery, represented in percent points [%], and State of Health (SOH) may be a current condition of a battery compared to its ideal or original conditions, represented in percent points [%].

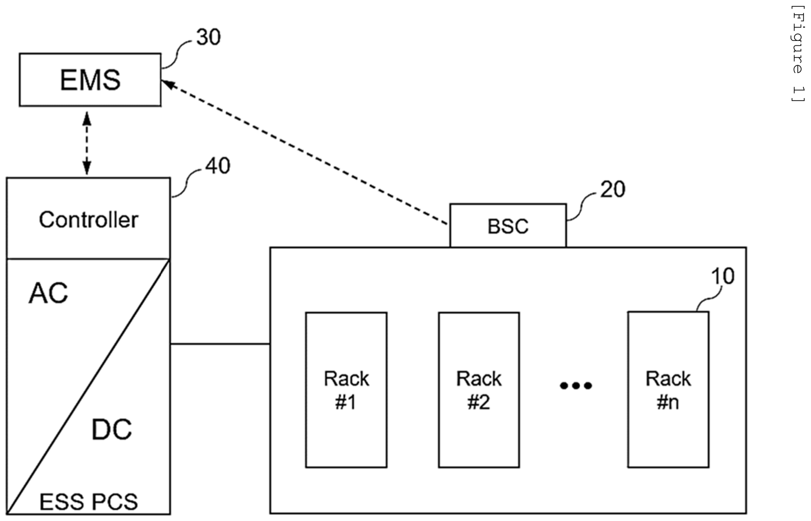

FIG. 1 is a block diagram of a general energy storage system.

In an energy storage system (ESS),a basic unit of battery for storing energy or power is a battery cell. Typycally, a seris/parallel combination of battery cells may form a battery module and multiple battery module may form a battery rack. In other words, a battery rack as a series/parallel combination of battery modules may be a basic unit of a battery system. Here, a battery module may be referred to as a battery pack depending on a device or a system in which the battery is used.

Referring to FIG.1, a battery rack 10 may include multiple battery modules and a battery protection unit or any other protection device. A battery rack may be monitored and controlled through a rack battery management system (rack BMS). The RBMS may monitor a current, a voltage and a temperature of each battery rack to be managed, calculate a state of charge (SOC) of the battery based on a monitoring result, and control charging and discharging.

Meanwhile, the battery protection unit (BPU) is a device for protecting the battery from abnormal current and fault current in a battery rack. The BPU may include a main contactor (MC), a fuse, a circuit breaker (CB), or a disconnect switch (DS). Here, the main contactor may include a positive main contactor and a negative main contactor. The BPU may control the battery system rack by rack by controlling the main contactor on/off according to control of the RBMS. The BPU may also protect the battery from short-circuit current by using a fuse when a short-circuit occurs. As such, a general battery system may be controlled through a protection device such as a BPU or a switch gear.

Meanwhile, a battery system controller (BSC) 20 may be located in each battery section which includes a plurality of batteries, peripheral circuits, and devices, so as to monitor and control objects such as a voltage, a current, a temperature, and a circuit breaker. The battery system controller may be a top-level controller of a bank-level battery system including a plurality of battery racks and is also used as a controller in a battery system with a multiple bank-level structure.

Furthermore, a power conversion system (PCS) 40 installed in each battery section may perform actual charging/discharging based on a charge/discharge command from an energy management system (EMS) 30. The power conversion system may include a power conversion unit (DC/AC inverter) and a controller. Meanwhile, the output of each BPU may be connected to a power generation device (e.g., phtovoltaic system) and the PCS 40 which is connected to a power grid, through a DC link (or DC bus). In addition, the energy management system (EMS) 30 or a power management system (PMS)may control the energy storage system in overall.

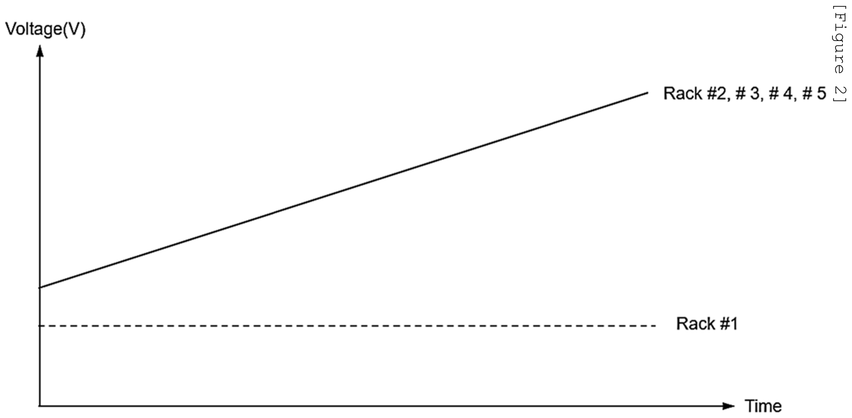

FIG. 2 is a graph for explaining a general battery control method.

In a battery system including a plurality of battery racks, when the racks are to be switched from a parallel disconnected state to a parallel connected state, racks having low voltage difference are selected and connected in parallel with each other to prevent inrush current from occurring in the battery system.

For example, if the voltages of the five racks (Rack #1 to #5) are [755 V, 800 V, 803 V, 799 V, 801 V] and the predefined voltage range is defined as 10 V, Rack #2, Rack #3, Rack #4, and Rack #5 may be connected to the DC link and connected in parallel with each other. Here, Rack #2 to #5 perform a charge/discharge process according to the operation mode of the battery system, and Rack #1, which is not connected to the DC link, stands-by in an idle mode.

In general, the off-line battery rack is connected to the DC link when the voltage of the off-line battery rack becomes the same as those of the on-line battery rack. However, in the case of an ESS linked to a PV (Photovoltaic; solar power generation) system, since the charge/discharge schedule of the battery system is determined in response to power generation status of the PV system, the period during which the battery system operates in charge mode or discharge mode is limited, and thus the period during which the offline battery rack cannot be switched to the online state may be long.

For example, as shown in Fig. 2, when the battery system operates in a charge mode, the voltage of Rack #2 to #5 increases for a certain period of time due to PV power. Accordingly, Rack #1, which is in the offline state, cannot be switched to an online state for a long period of time and remains in the offline state.

According to this general battery control method, since the period during which all battery racks cannot participate in the charge/discharge process becomes long, the charge/discharge efficiency of the battery system may be reduced.

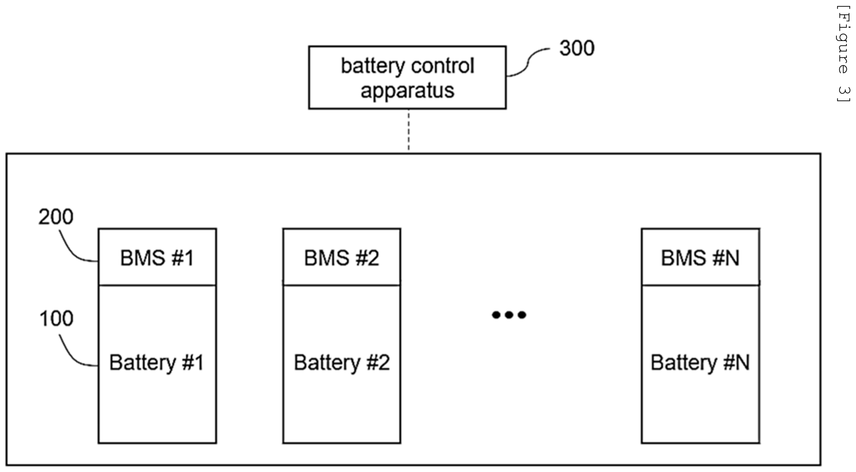

FIG. 3 is a block diagram of a battery system according to embodiments of the present invention.

Referring to FIG. 3, a battery system according to embodiments of the present invention may include a plurality of batteries 100, a plurality of battery management apparatuses200 that are provided corresponding to each of the plurality of batteries and manage and control the corresponding batteries, and a battery control apparatus 300 that is connected to and interoperate with the plurality of battery management apparatuses 200.

The battery 100 may mean a battery rack, but the scope of the present invention is not limited thereto. In other words, the battery 100 according to the present invention may correspond to a battery module, a battery pack, or a battery bank.

The batteries 100 may be configured to be connected in parallel with each other. Here, each of the batteries 100 may be electrically connected to a direct current (DC) link and connected in parallel with other batteries.

Each of the batteries 100 may include a switch arranged at an input/output terminal, and when the switch is switched from a closed state to an open state, the electrical connection with the DC link is cut off and the parallel connection with another battery may be released.

The battery management apparatus 200 may collect state information on a corresponding battery 100 and perform a predetermined control operation based on the collected state information, thereby managing and controlling the corresponding battery 100. Here, the battery management apparatus 200 may control charging and discharging of the battery and diagnose whether the battery cells are faulty based on the state information of the battery.

The battery management apparatus 200 may control the operation of the switch provided at the input/output terminal of the battery 100.

Each of the battery management apparatus 200 may be connected to the battery control apparatus 300 through a network, transmit battery state information to the battery control apparatus 300, and receive a control command from the battery control apparatus 300 to operate. Here, the battery management apparatus 200 may receive a switch control signal for controlling the operation of the switch from the battery control apparatus 300 and control on/off operation of the switch according to the switch control signal.

The battery control apparatus 300 may monitor and control the operation status of each of the battery management apparatuses 200.

The battery control apparatus 300 may correspond to a Battery System Controller (BSC), an Energy Management System (EMS), or a Power Management System (PMS).

The battery control apparatus 300 may collect state values of each battery while the parallel connection of the batteries 100 is disconnected, and select one or more target batteries that are targets for parallel connection based on the collected state values.

Thereafter, the battery control apparatus 300 may control the target batteries to be connected in parallel with each other. Here, the battery control apparatus 300 may transmit a switch control signal to a battery management apparatus of each of the target batteries to cause a switch to be switched to a closed state, thereby allowing the target batteries to be connected to a direct current (DC) link.

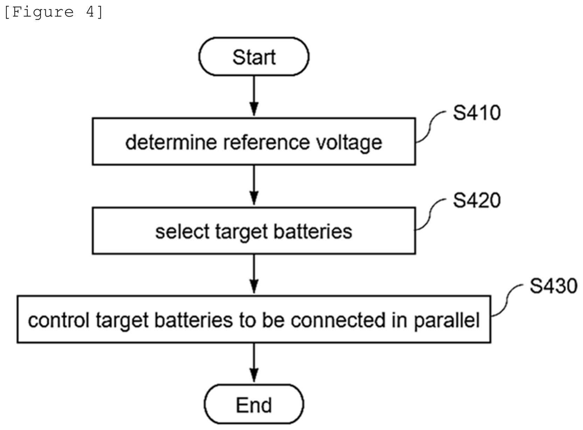

FIG. 4 is an operational flowchart of a battery control method according to embodiments of the present invention.

The battery control method according to embodiments of the present invention may be performed by a battery control apparatus located in a battery system including a plurality of batteries. Here, the battery control apparatus may correspond to an upper control apparatus that is connected and interoperates with the battery management apparatuses of each of the batteries, and may correspond to, for example, a Battery System Controller (BSC), an Energy Management System (EMS), or a Power Management System (PMS)that is connected and interoperates with a plurality of BMSs.

The battery control apparatus may determine a reference voltage based on the state value of each battery in a state that the parallel connection of the batteries is disconnected (S410). Here, the battery control apparatus may determine the reference voltage, when an event that the batteries need to be connected in parallel occurs, at the time of occurrence of the event (for example, an event in which the battery system switches from an idle mode to an operating mode).

The battery control apparatus may receive one or more state values of each battery from each battery management apparatus (for example, a BMS). Here, the battery state value may include at least one of a voltage value and a SOC value for each battery.

The battery control apparatus may identify the operation mode of the battery system and determine a reference voltage based on a reference voltage setting criterion defined in correspondence with the operation mode.

The operation mode may include at least one of a charge mode, a discharge mode, and a charge/discharge mixed mode. Here, the battery control apparatus may check whether the current battery system is operating in any one of the charge mode, the discharge mode, and the charge/discharge mixed mode.

The battery control apparatus may receive information about the operation mode from an upper control apparatus and determine the current operation mode of the battery system based on the received information. For example, if the battery control apparatus is a BSC, the battery control apparatus may receive information about the operation mode from its upper control apparatus, an EMS or PMS.

The battery control apparatus may determine the current operation mode of the battery system based on charge/discharge schedule information including the operation mode for each time interval. Here, the battery control apparatus may receive charge/discharge schedule information from the upper control apparatus.

For example, the charge/discharge schedule information may include data in which the operation mode for each time interval is defined, such as [00:00 ~ 11:00; discharge mode], [11:00 ~ 15:00; charge mode], [15:00 ~ 17:00; charge/discharge mixed mode], [17:00 ~ 24:00; discharge mode]. The battery control apparatus may receive the charge/discharge schedule information from the upper control apparatus and store it in a storage device. If a parallel connection event occurs at a specific time point, the battery control apparatus may identify the operation mode corresponding to the time point using the charge/discharge schedule information.

The reference voltage setting criteria for each of the operation modes may be defined differently.

In the charge mode, the lowest voltage value among the voltage values of the batteries may be set as a reference voltage, whereas, in the discharge mode, the highest voltage value among the voltage values of the batteries may be set as a reference voltage.

In the charge/discharge mixed mode, the voltage value of a specific battery among the batteries may be set as a reference voltage. Here, the battery having the voltage value used as the reference voltage may correspond to a battery having the largest number of other batteries that can be connected in parallel with each other.

The battery control apparatus may select one or more target batteries having a voltage within a predetermined range from a reference voltage set in S410 among the batteries (S420).

For example, if voltage values of each of the batteries (Bat #1 ~ Bat #5) are [755 V, 805 V, 810 V, 795 V, 765 V] and the current operation mode of the battery system is a charge mode, the reference voltage value may be set to 755 V. Here, if a predefined voltage range for target battery selection is 10 V, the battery control apparatus may determine Bat #1 and Bat #5 as target batteries.

For another example, if voltage values of each of the batteries (Bat #1 ~ Bat #5) are [755 V, 805 V, 810 V, 795 V, 765 V] and the current operation mode of the battery system is a discharge mode, the reference voltage value may be set to 810 V. Here, if the predefined voltage range for target battery selection is 10 V, the battery control apparatus may determine Bat #2 and Bat #3 as target batteries.

The battery control apparatus may control the target batteries selected in S420 to be connected in parallel with each other (S430).

Specifically, the battery control apparatus may control each of the target batteries to be connected to a DC link. Here, the battery control apparatus may control the target batteries to be connected in parallel with each other by transmitting a switch control signal to a battery management apparatus of each of the target batteries so that a switch connecting the battery and the DC link is switched to a closed state.

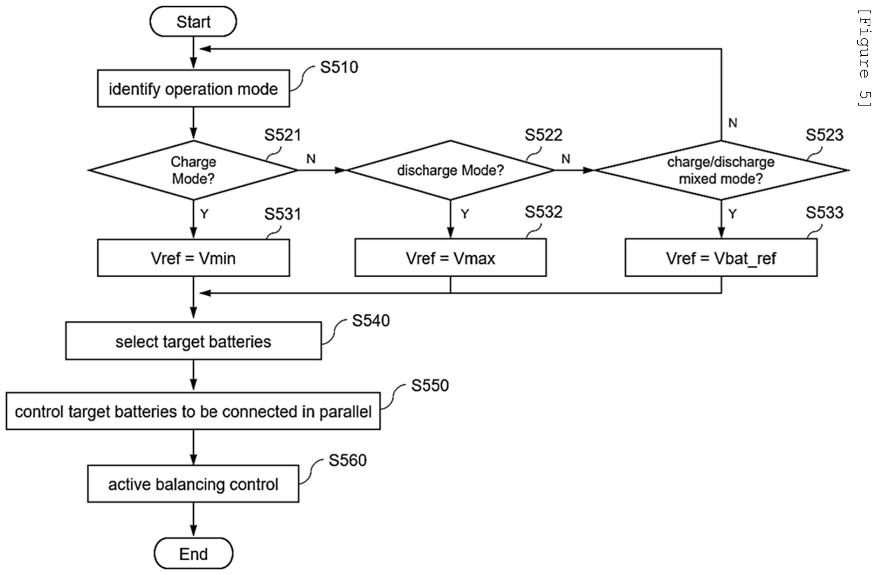

FIG. 5 is an operational flowchart of a battery control method according to another embodiment of the present invention.

When a parallel connection event occurs, the battery control apparatus may identify the current operation mode of the battery system (S510). Here, the battery control apparatus may check whether the current battery system is operating in one of a charge mode, a discharging mode, and a charge/discharge mixed mode.

The battery control apparatus may identify the current operation mode through an upper control apparatus, or determine the current operation mode using the current time and charge/discharge schedule information received from the upper control apparatus.

The battery control apparatus may determine the reference voltage based on the operation mode identified in S510.

If the current operation mode of the battery system is a charge mode (Y in S521), the battery control apparatus may determine the lowest voltage value (Vmin) among voltage values of the batteries as the reference voltage (Vref) (S531). For example, if voltage values of each of the batteries (Bat #1 ~ Bat #5) are [755 V, 805 V, 810 V, 795 V, 765 V], the reference voltage value may be set to 755 V.

If the current operation mode of the battery system is a discharge mode (Y of S522), the battery control apparatus may determine the highest voltage value (Vmax) among the voltage values of the batteries as the reference voltage (Vref) (S532). For example, if voltage values of each of the batteries (Bat #1 ~ Bat #5) are [755 V, 805 V, 810 V, 795 V, 765 V], the reference voltage value may be set to 810 V.

If the current operation mode of the battery system is a charge/discharge mixed mode (Y of S523), the battery control apparatus may select a specific battery among the batteries as a reference battery (Bat_ref) and set the voltage value (Vbat_ref) of the reference battery as the reference voltage (Vref) (S533). Here, the battery control apparatus may determine the battery with the largest number of other batteries that can be connected in parallel with the corresponding batery as the reference battery (Bat_ref).

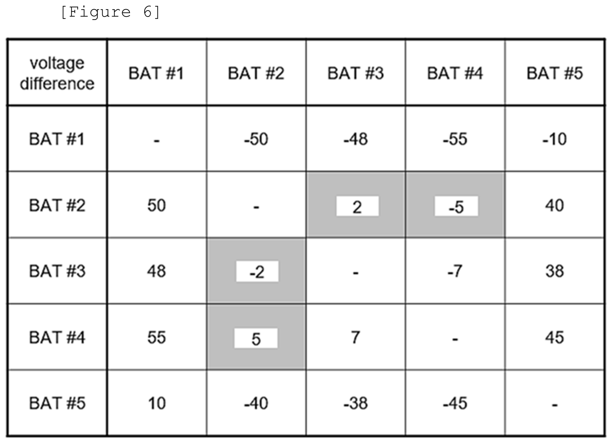

Hereinafter, a method for determining a reference voltage in a charge/discharge mixed mode according to embodiments of the present invention will be described in detail with reference to FIG. 6.

FIG. 6 is a reference table for explaining a method for determining a reference voltage in a charge/discharge mixed mode according to another embodiment of the present invention, and is an example of voltage difference between batteries.

The battery control apparatus may calculate, for each battery, a difference value between the state values of the batteries and that of another battery. For example, if voltage values of each of the batteries (Bat #1 to Bat #5) are [755 V, 805 V, 803 V, 810 V, 765 V], the battery control apparatus may calculate, for each of the batteries (Bat #1 to Bat #5), voltage difference values between the battery and another battery, as shown in FIG. 6.

Thereafter, the battery control apparatus may determine, for each of the batteries, a number of other batteries that can be connected in parallel. Here, the battery control apparatus may determine, for each of the batteries, the number of other batteries that have a voltage value within a predetermined range of the difference compared to its own state value, and determine the number of other batteries that can be connected in parallel.

Thereafter, the battery control apparatus may define the battery with the largest number of parallel-connectable batteries as a reference battery.

For example, if voltage difference values between the batteries (Bat #1 to Bat #5) is calculated as in FIG. 6, and the predefined voltage range for selecting the reference battery is ±5 V, the number of parallel-connectable batteries of each of the batteries (Bat #1 to Bat #5) may be determined as 0, 2, 1, 1, and 0. Here, the battery control apparatus may determine Bat #2 with the largest number of parallel-connectable batteries as the reference battery, and set the voltage value of Bat #2, 805 V, as the reference voltage (Vref).

Referring back to FIG. 5, the battery control apparatus may select one or more target batteries having voltages within the preset range from the reference voltage in S531 to S533 (S540).

For example, if the voltage values of each of the batteries (Bat #1 ~ Bat #5) are [755 V, 805 V, 810 V, 795 V, 765 V] and the current operation mode of the battery system is a charge mode, the reference voltage value may be set to 755 V (S531). Here, if the predefined voltage range for target battery selection is 10 V, the battery control apparatus may determine Bat #1 and Bat #5 as target batteries.

For another example, if the voltage values of each of the batteries (Bat #1 ~ Bat #5) are [755 V, 805 V, 810 V, 795 V, 765 V] and the current operation mode of the battery system is a discharge mode, the reference voltage value may be set to 810 V (S532). Here, if the predefined voltage range for target battery selection is 10 V, the battery control apparatus may determine Bat #2 and Bat #3 as target batteries.

For another example, if the voltage values of each of the batteries (Bat #1 ~ Bat #5) are [755 V, 805 V, 803 V, 810 V, 765 V] and the current operation mode of the battery system is a charge/discharge mixed mode, the reference voltage value may be set to 805 V (S533). Here, if the predefined voltage range for target battery selection is ±5 V, the battery control apparatus may determine Bat #2, Bat #3, and Bat #4 as target batteries.

The battery control apparatus may control the target batteries selected in S540 to be connected in parallel with each other (S550).

Specifically, the battery control apparatus may control each of the target batteries to be connected to a DC link. Here, the battery control apparatus may control the target batteries to be connected in parallel with each other by transmitting a switch control signal to a battery management apparatus of each of the target batteries so that a switch connecting the battery and the DC link is switched to a closed state.

Thereafter, the battery system may operate according to the current operation mode while the target batteries are being connected to the DC link.

The battery control apparatus may perform active balancing control based on the voltage difference between the target battery (online battery) and the remaining battery (offline battery) during the operation process of the battery system (S560).

Specifically, the battery control apparatus may monitor the voltage difference between the target batteries and off-line batteries during a process of charging or discharging the target batteries according to the operation mode. Here, the battery control apparatus may connect at least one battery among the off-line batteries, whose voltage difference with the target batteries falls into a predetermined range, to the DC link, thereby connecting the corresponding battery in parallel with the target batteries.

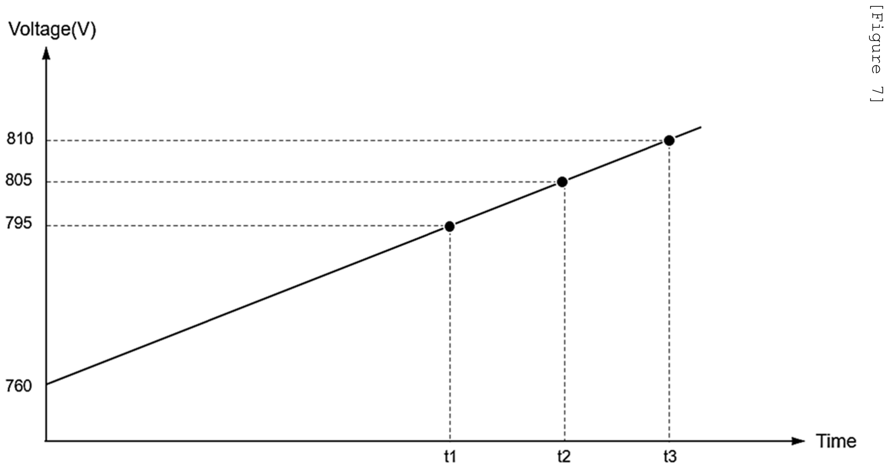

Hereinafter, with reference to FIGS. 7 to 9, an active balancing method for each operation mode according to embodiments of the present invention will be described.

FIG. 7 is a graph for explaining an active balancing method in a charging mode according to an embodiment of the present invention.

When voltage values of each of the batteries (Bat #1 to Bat #5) are [755 V, 805 V, 810 V, 795 V, 765 V], the reference voltage value may be set to 755 V. Here, when the predefined voltage range for target battery selection is 10 V, the target batteries are determined as Bat #1 and Bat #5, and thus, Bat #1 and Bat #5 are connected to a DC link.

As the battery system operates in a charge mode, the voltages of Bat #1 and Bat #5 gradually increase from the average voltage of 760 V.

The battery control apparatus may monitor the difference between the average voltage of the online batteries (Bat #1, #5) and the voltage of each of the offline batteries (Bat #2, #3, #4). Here, the battery control apparatus may connect batteries, among the offline batteries (Bat #2, #3, #4), whose voltage difference with the online batteries (Bat #1, #5) falls into a predetermined range to the DC link and switch it to an online state.

If the predetermined voltage range for switching the offline battery to an online state is ±1 V, the battery control apparatus may connect Bat #4 to the DC link at time t1 and switch it to an online state. Thereafter, the battery control apparatus may connect Bat #2 to the DC link at time t2 and switch it to an online state. Thereafter, the battery control apparatus may connect Bat #3 to the DC link at time t3 and switch it to an online state.

In a charge mode, since the lowest voltage value among the voltage values of the batteries is set as the reference voltage, batteries in a low voltage range may participate in the charge process at the time when the battery system starts operating. Thereafter, during the charging process, the remaining batteries sequentially participate in the charge process, and eventually, all batteries can participate in the charge process.

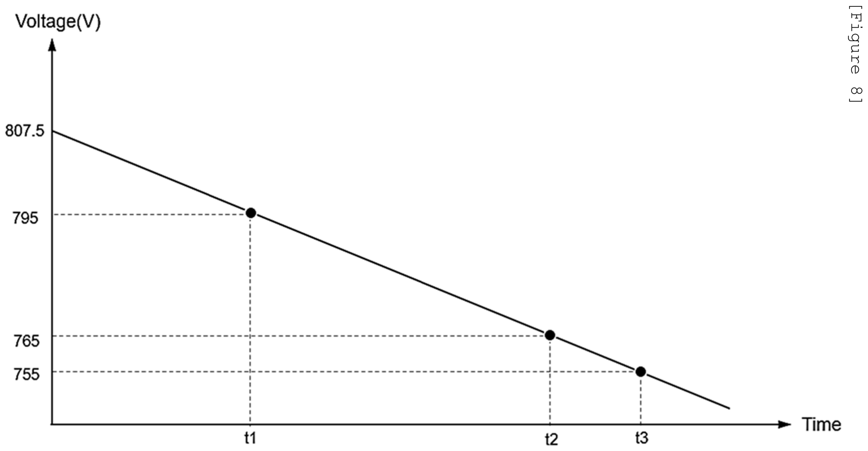

FIG. 8 is a graph for explaining an active balancing control method in a discharge mode according to an embodiment of the present invention.

When voltage values of each of the batteries (Bat #1 to Bat #5) are [755 V, 805 V, 810 V, 795 V, 765 V], the reference voltage value may be set to 810 V. Here, when the predefined voltage range for target battery selection is 10 V, the target batteries are determined as Bat #2 and Bat #3, and thus, Bat #2 and Bat #3 become connected to the DC link.

As the battery system operates in a discharge mode, the voltages of Bat #2 and Bat #3 gradually decrease from the average voltage of 807.5 V.

The battery control apparatus may monitor the difference between the average voltage of the online batteries (Bat #2, #3) and the voltage of each of the offline batteries (Bat #1, #4, #5). Here, the battery control apparatus may connect the battery, among the offline batteries (Bat #1, #4, #5), whose voltage difference with the online batteries (Bat #2, #3) falls into a predefined range to the DC link and switch it to an online state.

If the predefined voltage range for switching the offline battery to an online state is ±1 V, the battery control apparatus may connect Bat #4 to the DC link at time t1 and switch it to an online state. Thereafter, the battery control apparatus may connect Bat #5 to the DC link at time t2 and switch it to an online state. Afterwards, the battery control apparatus may connect Bat #1 to the DC link at time t3 and switch it to an online state.

In a discharge mode, since the highest voltage value among the voltage values of the batteries is set as the reference voltage, batteries in a high voltage range may participate in the discharge process at the time when the battery system starts operating. Thereafter, during the discharge process, the remaining batteries sequentially participate in the discharge process, and eventually, all batteries can participate in the discharge process.

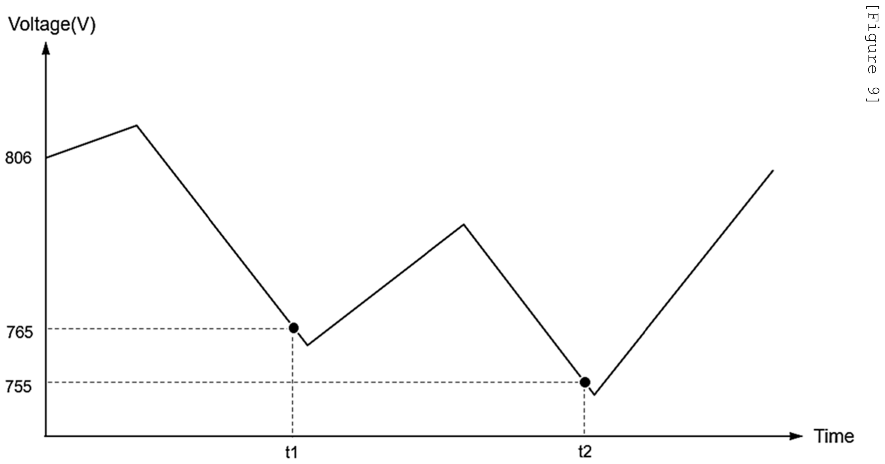

FIG. 9 is a graph for explaining an active balancing control method in a charge/discharge mixed mode according to an embodiment of the present invention.

When voltage values of each of the batteries (Bat #1 to Bat #5) are [755 V, 805 V, 803 V, 810 V, 765 V], the reference voltage value may be set to 805 V. Here, when the predefined voltage range for target battery selection is ±5 V, the target batteries are determined as Bat #2, Bat #3, and Bat #4, and thus, Bat #2, Bat #3, and Bat #4 are connected to the DC link.

As the battery system operates in a charge/discharge mixed mode, the voltages of Bat #2, Bat #3, and Bat #4 may increase or decrease from the average voltage of 806 V.

The battery control apparatus may monitor the difference between the average voltage of the online batteries (Bat #2, #3, #4) and the voltage of each of the offline batteries (Bat #1, #5). Here, the battery control apparatus may connect the battery, among the offline batteries (Bat #1, #5), whose voltage difference with the online batteries (Bat #2, #3, #4) falls into a preset range to the DC link and switch it to an online state.

If the predefined voltage range for switching the offline battery to an online state is ±1 V, the battery control apparatus may connect Bat #5 to the DC link at time t1 and switch it to an online state. Thereafter, the battery control apparatus may connect Bat #1 to the DC link at time t2 and switch it to an online state.

In the charge/discharge mixed mode, since the voltage value of the battery with the largest number of other batteries that can be connected in parallel is set as the reference voltage, the largest number of batteries may participate in the charge process within a range where inrush current does not occur at the time when the battery system starts operation. Thereafter, during the charge or discharge process, the remaining batteries sequentially participate in the charge/discharge process, so that as many batteries as possible can participate in the charge/discharge process.

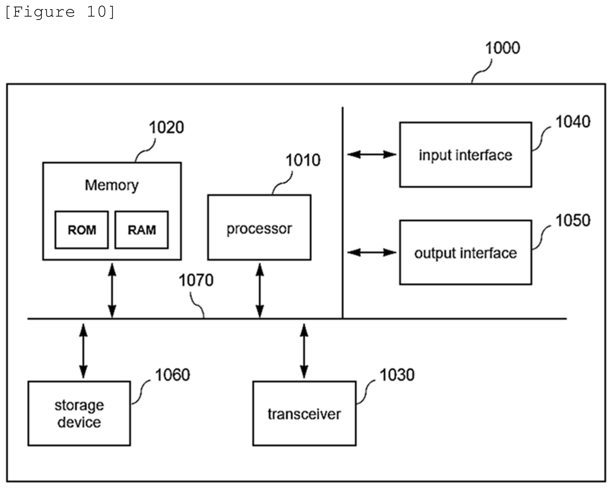

FIG. 10 is a block diagram of a battery control apparatus according to embodiments of the present invention.

The battery control apparatus 1000 according to embodiments of the present invention may be located in a battery system and linked with a battery management apparatus of each battery. For example, the battery control apparatus 1000 may correspond to a Battery System Controller (BSC), an Energy Management System (EMS), or a Power Management System (PMS), or may be implemented by being included in any one of them.

The battery control apparatus 1000 may include at least one processor 1010, a memory 1020 that stores at least one instruction executed by the processor, and a transceiver 1030 that is connected to a network and performs communication.

Here, the at least one instruction may include an instruction to identify an operation mode of the battery system; an instruction to determine a reference voltage based on a reference voltage setting criterion defined in correspondence with the identified operation mode; an instruction to select one or more target batteries having a voltage within a predetermined range from the reference voltage; and an instruction to control the target batteries to be connected in parallel with each other.

The operation mode may include one or more of a charge mode, a discharge mode, and a charge/discharge mixed mode.

The instruction to identify the operation mode of the battery system may include an instruction to determine a current operation mode of the battery system based on charge/discharge schedule information including an operation mode for each time interval.

The instruction to determine the reference voltage may include an instruction to determine the lowest voltage value among voltage values of the batteries as the reference voltage when the battery system operates in a charge mode.

The instruction to determine the reference voltage may include an instruction to determine the highest voltage value among voltage values of the batteries as the reference voltage when the battery system operates in a discharge mode.

The instruction to determine the reference voltage may include an instruction to determine a voltage value of a specific battery among the batteries as the reference voltage when the battery system operates in a charge/discharge mixed mode.

The instruction to determine the reference voltage may include an instruction to determine, for each of the batteries, a number of other batteries each of which has a voltage value within a predetermined range of difference from the voltage value of each battery; and an instruction to determine the voltage value of the battery having the largest number of the other batteries, as the reference voltage.

The at least one instruction may further include an instruction to connect, in parallel with the target batteries, one or more batteries whose voltage difference with the target batteries falls into a predetermined range during a process of charging or discharging the target batteries, among one or more batteries from which the parallel connection has been disconnected.

The instruction to control the target batteries to be connected in parallel with each other may include an instruction to transmit a switch control signal for causing a switch connecting the battery and a direct current (DC) link to be switched to a closed state to a battery management apparatus of each of the target batteries.

The battery control apparatus 1000 according to embodiments of the present invention may further include an input interface device 1040, an output interface device 1050, a storage device 1060, etc. Respective components included in the battery control apparatus 1000 may be connected by a bus 1070 and can communicate with each other.

Here, the processor 1010 may mean a central processing unit (CPU), a graphics processing unit (GPU), or a dedicated processor on which methods according to embodiments of the present invention are performed. The memory (or storage unit) may include at least one of a volatile storage medium and a nonvolatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery control apparatus located in a battery system including a plurality of batteries, the apparatus comprising:
at least one processor; and
a memory configured to store at least one instruction executed by the at least one processor,
wherein the at least one instruction includes:
an instruction to identify an operation mode of the battery system;
an instruction to determine a reference voltage based on a reference voltage setting criterion defined in correspondence with the identified operation mode;
an instruction to select one or more target batteries having a voltage within a predetermined range from the reference voltage; and
an instruction to control the target batteries to be connected in parallel with each other.

2. The apparatus of claim 1, wherein the operation mode includes one or more of a charge mode, a discharge mode, and a charge/discharge mixed mode.

3. The apparatus of claim 2, wherein the instruction to identify the operation mode of the battery system includes:
an instruction to determine a current operation mode of the battery system based on charge/discharge schedule information including an operation mode for each time interval.

4. The apparatus of claim 1, wherein the instruction to determine the reference voltage includes:
an instruction to determine the lowest voltage value among voltage values of the batteries as the reference voltage when the battery system operates in a charge mode.

5. The apparatus of claim 1, wherein the instruction to determine the reference voltage includes:
an instruction to determine the highest voltage value among voltage values of the batteries as the reference voltage when the battery system operates in a discharge mode.

6. The apparatus of claim 1, wherein the instruction to determine the reference voltage includes:
an instruction to determine a voltage value of a specific battery among the batteries as the reference voltage when the battery system operates in a charge/discharge mixed mode.

7. The apparatus of claim 6, wherein the instruction to determine the reference voltage includes:
an instruction to determine, for each of the batteries, a number of other batteries each of which has a voltage value within a predetermined range of difference from the voltage value of each battery; and
an instruction to determine the voltage value of the battery having the largest number of the other batteries, as the reference voltage.

8. The apparatus of claim 1, wherein the at least one instruction further includes:
an instruction to connect, in parallel with the target batteries, one or more batteries whose voltage difference with the target batteries falls into a predetermined range during a process of charging or discharging the target batteries, among one or more batteries from which the parallel connection has been disconnected.

9. The apparatus of claim 1, wherein the instruction to control the target batteries to be connected in parallel with each other includes:
an instruction to transmit a switch control signal for causing a switch connecting the battery and a direct current DC link to be switched to a closed state to a battery management apparatus of each of the target batteries.

10. A battery control method performed by a battery control apparatus located in a battery system including a plurality of batteries, the method comprising:
identifying an operation mode of the battery system;
determining a reference voltage based on a reference voltage setting criterion defined in correspondence with the identified operation mode;
selecting one or more target batteries having a voltage within a predetermined range from the reference voltage; and
controlling the target batteries to be connected in parallel with each other.

11. The method of claim 10, wherein the operation mode includes one or more of a charge mode, a discharge mode, and a charge/discharge mixed mode.

12. The method of claim 11, wherein the identifying the operation mode of the battery system includes:
determining a current operation mode of the battery system based on charge/discharge schedule information including an operation mode for each time interval.

13. The method of claim 10, wherein the determining the reference voltage includes:
determining the lowest voltage value among voltage values of the batteries as the reference voltage when the battery system operates in a charge mode.

14. The method of claim 10, wherein the determining the reference voltage includes:
determining the highest voltage value among voltage values of the batteries as the reference voltage when the battery system operates in a discharge mode.

15. The method of claim 10, wherein the determining the reference voltage includes:
determining a voltage value of a specific battery among the batteries as the reference voltage when the battery system operates in a charge/discharge mixed mode.

16. The method of claim 15, wherein the determining the reference voltage includes:
determining, for each of the batteries, a number of other batteries each of which has a voltage value within a predetermined range of difference from the voltage value of each battery; and
determining the voltage value of the battery having the largest number of the other batteries, as the reference voltage.

17. The method of claim 10, further comprising:
connecting, in parallel with the target batteries, one or more batteries whose voltage difference with the target batteries falls into a predetermined range during a process of charging or discharging the target batteries, among one or more batteries from which the parallel connection has been disconnected.

18. The method of claim 10, wherein the controlling the target batteries to be connected in parallel with each other includes:
transmitting a switch control signal for causing a switch connecting the battery and a direct current DC link to be switched to a closed state to a battery management apparatus of each of the target batteries.
